# EUROPEAN PATENT SPECIFICATION

(11) **EP 1 465 757 B1**
(45) Date of publication and mention of the grant of the patent: **22.10.2008**
(21) Application number: 02793307.6
(22) Date of filing: 12.12.2002
(51) Int. Cl.: B29B 9/00

(54) **A THERMAL PROCESS INVOLVING COLD RF IRRADIATED LIQUID AS A CORE METHOD FOR PRODUCING NANO-SIZE PARTICLES**
WÄRMEPROZESS MIT KALTER HF-BESTRAHLTER FLÜSSIGKEIT ALS KERNVERFAHREN ZUR HERSTELLUNG VON TEILCHEN IN NANOGRÖSSE
PROCESSUS THERMIQUE FAISANT APPEL A UN LIQUIDE FROID EXPOSE A UN RAYONNEMENT RF UTILISE COMME PROCEDE DE BASE POUR LA PRODUCTION DE NANOPARTICULES

(30) Priority: 12.12.2001 IL 14704901
(43) Date of publication of application: 13.10.2004
(73) Proprietor: Do-Coop Technologies Ltd, 60408 Or Yehuda (IL)
(72) Inventor: GABBAI, Eran, 49925 Kfar Maas (IL)
(74) Representative: Schmitz, Jean-Marie
(86) International application number: PCT/IL2002/001004
(87) International publication number: WO 2003/053647

(56) References cited:
- US-A- 5 585 020
- US-A- 5 665 277
- US-A- 6 103 868

## Description

### Scientific background

It is well known that nano-size particles of 5-150 nm in diameter, produced by bottom-up methods such as sol gel or other chemical methods, tend to loose the physical properties characterizing the bulk, unless further treatment is involved in the production process. This additional treatment turns the above-mentioned production processes into either expensive or cumbersome processes. Many of nowadays-exciting applications involve nano-size materials. As many physical properties of the bulk are lost during the production of nano-size materials, the range of applications considerably narrows. The method described hereby overcomes these drawbacks, by offering a relatively simple and chip top-down process for the production of nanoparticles.

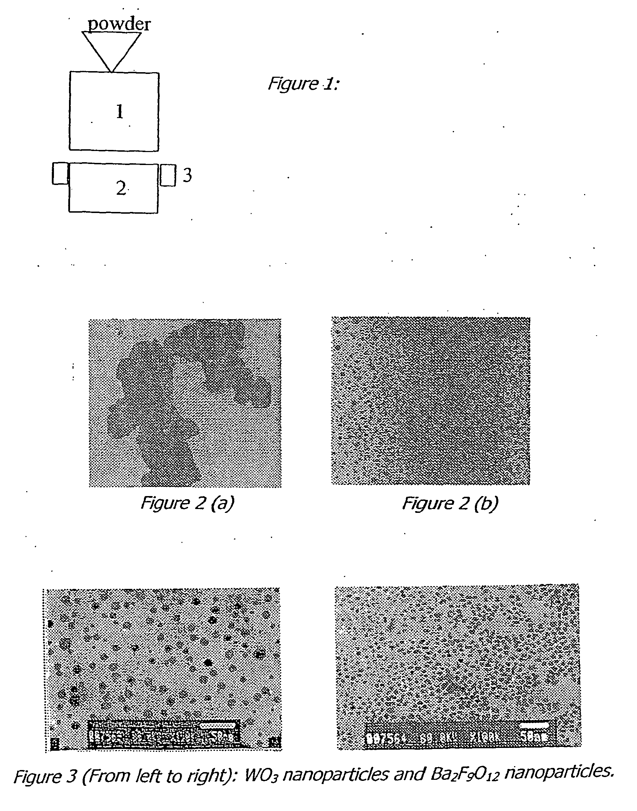

### Process Description (Fig 1)

In principle our technology is based on dropping a heated powder into RF irradiated colder liquid: As depicted in figure 1, a given quantity of micro-size powder is preheated to several hundreds centigrade by a furnace (1). The heated powder is dropped into a container of liquid (2). The liquid in the container, which is being constantly cooled, is subjected to a CW/modulated RF radiation. RF power is supplied by an antenna (3) in the vicinity of the cold liquid container.

The principles of the process can be applied in many ways. The heated powder can be dropped into the cold liquid either at once as a chunk, or continuously through a tube furnace. The liquid can be cooled by an external refrigerating device or by circulating it through a cooling pump. The RF radiation can be applied through various types and shapes of antennas.

### Process Outcome (see Fig 2)

Figure 2 is a typical example of the capabilities of the above-described - process: Figure 2(a) is a TEM photograph of the micro-size BaTiO₃ powder while Figure 2(b) is a TEM photograph of the nano-size particles produced according to the above-described process, with parameters specifically chosen for BaTiO₃:
Source powder: 0.3 g Micro-size BaTiO₃
Furnace temperature: 880°C
Liquid (water) temperature: 2°C
Cooling method: cooling bath
RF frequency: CW 915 MHz with an additional metal reflector

Other examples of nanoparticle products are shown in Figure 3: WO₃ nanoparticles, and Ba₂F₉O₁₂ nanoparticles. The production parameters are obviously different from those of the BaTiO₃ within a limited range. However, once the right parameters are optimized each material has a recipe according to which nanoparticles of this material are reproducibly produced

### 1. Scientific Introduction

With the newly dawned age of nanoscience and nanotechnology, it is expected that nanotubes and nanoparticles will play a crucial role in many branches of future technology, especially in microelectronics, MEMS and interfaces between man-made and biological systems (see, for example, the latest Scientific American issue, September 2001 - Nanotech).

Ferroelectric and ferromagnetic nanoparticles are examples of nanoparticles, which are already in demand by the microelectronics industry and much effort is devoted to their production. .

In general, there is a need for methods of production of nanoparticles, which retain the properties of the larger micron-size particles, such as, superconductivity, ferroelectricity, ferromagnetism, piezoelectricity etc.

Here we give the specific example of ferroelectricity, but the same argumentation is relevant to other kinds of nanoparticles properties.

### 2. The Need for Ferroelectric and Ferromagnetic Nanoparticles

### 2.1 Ferroelectricity - Background

A ferroelectric material is a material that maintains, over some temperature range, a permanent electric polarization that can be reversed or reoriented by the application of an electric field.

Ferroelectric metal oxide compounds have attracted attention since the early 40's, with the discovery of the phenomenon of ferroelectricity as the source of the unusually high dielectric constant in ceramic barium titanate capacitors (which permits the production of small geometric capacitors with high capacity). Since then, ferroelectric ceramics have been the heart and soul of several multibillion-dollar industries.

One of the major uses of ferroelectric materials is in non-volatile memory storage devices, as they allow of smaller memory cells, lower write voltage, shorter write time and lower write energy than the currently used, silicon based memory devices.

As ferroelectric materials are also pyroelectric and piezoelectric, other applications for sensors and actuators exist: uncooled IR detectors, optical waveguides, light modulators, frequency doublers, piezoelectric transducers, positive temperature coefficient devices, etc.

In the light of the above, the growing need for ferroelectric thin films is obvious.

### 2.2 Current Technological Barriers

Despite the vast potential for applications of ferroelectric thin films, commercial use has been hindered by technological problems. Thin films produced in the current methods for production of thin films of such materials (barium titanate, lead zirconate titanate, strontium barium titanate), are not fully crystalline and frequently are highly defective. This has a negative effect on the performance of the films as the non-volatile memory platform, and causes quality degradation over time.

Attempts were made to overcame this difficulty. However, the methods developed turned out to be too expensive or too cumbersome for practical application.

### 2.4. Ferromagnetism - Background

With analogy to a ferroelectric material, a ferromagnetic material is a material that maintains permanent magnetization, which is reversible by applying a magnetic field.

Ferromagnetic thin films are widely used in magnetic data storage media The technical obstacles encountered by ferroelectric thin film production are similar to those encountered by ferromagnetic thin film production: poor crystalline character and high inhomogeneousity.

### 2.3 The Nanoparticle Solution

A promising technique for producing high quality thin films would be to coat surface with ferroelectric nanoparticles. Unfortunately, the same problem persists: nanoparticles produced by current methods do not retain their Ferroelectric properties. The novel technology that we propose, promises to overcome the above problems, as we developed a novel process for the production of various kinds of nanoparticles, which retain the macroscopic properties of ferroelectricity, ferromagnetism and piezoelectrisity.

### 3. Our Nanoparticle Thin Film Technology

With the growing realization of the importance of nanoparticles, and the following effort in the field, many methods for producing nanoparticles have been developed.

A common element in all other methods of producing nanoparticles is the "bottom-up" approach: The desired nanoparticles are produced either by reacting the composing materials or by aggregating the building blocks.

Our approach is "top-down". We start with µm-size (larger than 10µm) chunks, and break them, in a controlled manner, into nm-size particles, 5-50 nm, while retaining their crystalline properties:

Our technology is based on dropping a heated powder into RF irradiated cold water. This process is based on principles that are not yet common knowledge in the scientific community.

The method is manifested through the development of a special production apparatus - the Neotron, which produces "top-down" nanoparticles, that retain the properties of the original powder - the Nanasons.

### 4. A detailed description of the Neotron

The apparatus designed for the production of nanoparticles is composed of four main components, from top to bottom:
1. A meshed stainless steel sieve
2. A furnace
3. A RF source
4. A cooling bath.

And is using the principles described within the concept document describing the thermal process involving cold RF irradiated liquid as a core method for producing nano-size particles.

Precise control of the production parameters is indispensable for successful results. Therefore:
1. In order to control the heat contents of the precursor particles one can size-select the particles of the precursor powder. Hence a vibrating meshed sieve can be mounted on top of the apparatus.
2. The precursor particles fall downwards through a tube furnace. This tube furnace can reach a maximum temperature of 1050°C. Alternatively a quanta (of the order of 0.5g) of the source powder is held in on a ceramic tube inserted in a regular furnace and after heated are dropped down into cold water. The heated source powder is dropped into cold (below 4°c) water.
3. The water is also RF irradiated during the production at a frequency of above 800MHz.
4. The water into which powder is being dropped can be added with a small amount of detergent (0.5 mM) resulting a slightly basic pH (> 7)

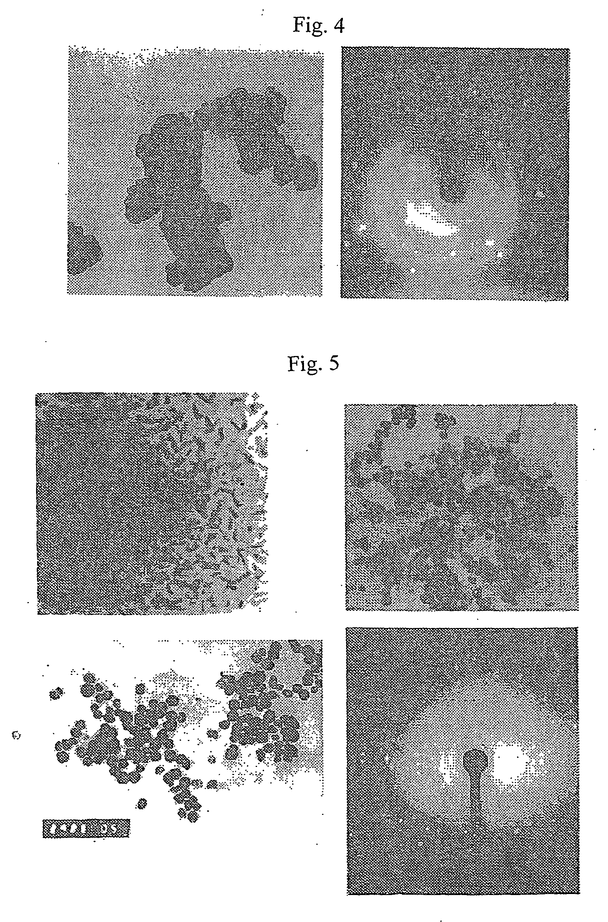

Figure 4 shows a TEM (Transmission Electron Microscope) photograph of the µm-size source powder, together with its electron diffraction pattern. This proves that the µm-size powder is crystalline.

Figure 5 is a selection of TEM photographs of our nanoparticles in several sizes and shapes, together with a typical electron diffraction pattern, showing that these nanoparticles are crystalline.

Figure 6 is a typical AFM photograph of a mica surface coated with these nanoparticles. Note the ordering of the particles on the surface.

### Hydro-RF production of order inducing nanoparticles

### Scientific Background

Water is one of the most remarkable and important substances known in nature. It is the most abundant substance on earth and has been very well studied. Although it appears to be a very simple molecule consisting of two hydrogen atoms attached to an oxygen atom, it has complex properties. Water has numerous special properties due to hydrogen bonding, such as high surface tension, high viscosity, and the capability of forming ordered hexagonal, pentagonal of dodecahedral water arrays by themselves of around other substances (See S. Mashimo and I. M. Svishchev).

Most water properties are attributed to the hydrogen bonding occurring when an atom of hydrogen is attracted by rather strong forces to two atoms instead of only one, so that it can be considered to be acting as a bind between them. These hydrogen bonds are strong and occur frequently among water molecules. The hydrogen bonds create extensive networks that can form numerous hexagonal, pentagonal of dodecahedral water arrays. These networks are aided by bonded cooperativity. The Hydrogen-bonded network possesses a large extent of order. Additionally, there is temperature dependent competition between the ordering effects of hydrogen bonding and the disordering kinetic effects (See L. Pauling and T. Lijima and K. Nishikawa).

As known, water molecules can form ordered structures and superstructures. For example, shells of ordered water form around various biomolecules such as proteins and carbohydrates. The ordered water environment around these biomolecules are strongly involved in biological function with regards to intracellular function including, but not limited to, signal transduction from receptors to cell nucleus. Additionally these water structures are stable and can protect the surface of the molecule.

Most of the ordered structure of liquefied water is on a short-rang scale (1 nm). Although long-range order exists, it is nearly impossible, with liquid water, because molecules in a liquid state are in constant thermal, motion. Due to the hydrogens bonding and the non-bonding interactions, water molecules can form an infinite hydrogen-bonded network with specific and structured clustering. Thus, small clusters of water molecules can form water octamers that can further cluster with other smaller clusters to form icosahedral water clusters consisting of hundreds of water molecules. Therefore, water molecules can form ordered structures and other shaped arrays.

### Objectives of the Invention

The invention is a method for the production of novel nanoparticles (nanococoons) immersed in water in a way to induce stable long-range orientational order similar to that induced by irradiating water with RF radiation (See extensive studies by M. Colic and D. Morse). Referred to as NeoWater.

### Detailed Description of the invention

Generally, the present invention provides for nanococoons composed of a core of modified particulate material enclosed by a shell of ordered water molecules. Additionally, the present invention provides for a method of manufacturing the nanococoons.

The term "nanococoons" as used herein is meant to include, but is not limited to, the combination of the modified particulate material surrounded by ordered water molecules. The ordered molecules and the immersion fluid in which the process occurs are the same - they are both water.

The term "modified particulate material" as used herein is meant to include, but is not limited to, the materials of the present invention that form the core of the nanococoons.

The terms "ordered", "ordered layer" "ordered fluid molecules" and "ordered molecules" as used herein are meant to include, but are not limited to, a specially organized arrangement of fluid molecules with orientational correlations. These molecules form capsule arrays or structures surrounding the modified particulate material. The fluid molecules will cover at least one surface of the modified particulate material.

The term "parent material" as used herein is meant to include, but is not limited to, materials from which the modified particulate materials are derived. The parent material can be non-conductive or conductive. The parent materials include, but are not limited to, minerals, ceramic materials, glasses, metals, synthetic polymers, and any other similar materials. The present invention uses material that include, but are not limited to, PbZrTiO₃, ZrO₃, Al₂O₃. The size of the particles of which the parent material is made of is reduced to nanoparticles before they can be processed into modified particulate materials. The desired size can be obtained through any method.

The present invention provides a nanococoon and its production thereof. In its most basic form the nanococoon is composed of a modified particulate material surrounded and/or coated by ordered fluid molecules. The core of modified particulate materials varies in size and is derived from any number of different materials. The ordered fluid molecules surrounding the core are made of the molecules in which the core of modified particulate material is placed. Additionally, the ordered, fluid molecules can form either a monolayer or multiple layer shell around the modified particulate material.

### The Nanococoon and NeoWater Production Procedure

The apparatus designed for the production of nanococoons is composed of two main components, from top to bottom:
1. Furnace of up to 1200°C.
2. Cooling bath with RF antenna.

And is using the principles described within the concept document describing the thermal process involving cold RF irradiated liquid as a core method for producing nano-size particles.

Precise control of the production parameters is indispensable for successful results. Therefore:
The production process is composed of two stages:
1. Heating source powder of the "Parent Material" to a temperature range of 700-1200°C.
2. The heated powder is dropped into cold water (below 4°C) which are irradiated by RF radiation at frequencies range of 500-2000 MHz.

### A Demonstration of the NeoWater effect on Electrochemical Deposition (ECD) Patterns

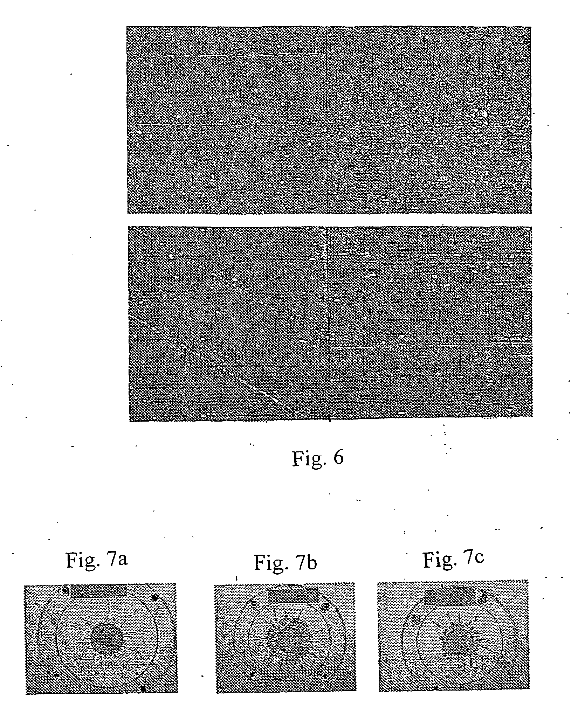

Figure 7 demonstrates the effect of the nanocoocons on the ECD patterns. Note the impressive resemblance between the RF and NeoWater dense pattern, which are both different from the sparse non-treated water pattern.

## Claims

1. A method of making nanoparticles, comprising the steps of:
(a) heating a solid powder;
(b) immersing said solid in a liquid that is colder than said hot powder; and
(c) during said immersing, irradiating said liquid with RF radiation,
said immersing and said irradiating serving to break up said powder into the nanoparticles.

2. The method of claim 1, wherein said solid powder includes micron-size particles.

3. The method of claim 1, wherein both said powder and the nanoparticles are crystalline.

4. The method of claim 1, wherein said liquid includes water.

5. The method of claim 1, wherein said solid is selected from the group consisting of ferroelectric solids and ferromagnetic solids.

6. The method of claim 1, wherein said solid is selected from the group consisting of BaTiO₃, W0₃ and Ba₂F₉O₁₂.

7. The method of claim 1, wherein said solid is selected from the group consisting of minerals, ceramics, glasses, metals and synthetic polymers.

8. The method of claim 1, wherein said RF radiation is CW RF radiation.

9. The method of claim 1, wherein said CW RF radiation has a frequency of at least 500 MHz.

10. The method of claim 1, wherein said CW RF radiation has a frequency of at least 800 MHz.

11. The method of claim 1, wherein said powder is heated to at least 700 °C.

12. The method of claim 1, wherein said powder is heated to at least 880 °C.

13. Nanoparticles produced by the method of claim 1.

14. Ferroelectric crystalline nanoparticles produced by the method of claim 3.

15. Ferromagnetic crystalline nanoparticles produced by the method of claim 3.

16. Piezoelectric crystalline nanoparticles produced by the method of claim 3.

17. An apparatus for converting a solid powder into nanoparticles, comprising:
(a) a furnace for heating the powder;
(b) a container of a liquid into which said hot powder is dropped to cool and break up the hot powder; and
(c) a mechanism for irradiating said liquid with RF radiation while said hot powder is dropped into said liquid.

18. The apparatus of claim 17, wherein said furnace is a tube furnace.

19. The apparatus of claim 17, further comprising:
(d) a meshed sieve for selecting a particle size of the powder, only particles of said selected size then being heated in said furnace.

20. The apparatus of claim 17, wherein said furnace is operative to heat the powder to at least 700 °C.

21. The apparatus of claim 17, wherein said RF radiation is CW RF radiation having a frequency of at least 500 MHz.

## Patentansprüche

1. Verfahren zur Herstellung von Nanopartikeln, umfassend die Schritte des:
(a) Erhitzens eines Feststoffpulvers;
(b) Eintauchens des Feststoffs in eine Flüssigkeit, die kälter als das heiße Pulver ist; und,
(c) während dieses Eintauchens, Bestrahlens der Flüssigkeit mit HF-Strahlung,
wobei das Eintauchen und Bestrahlen zum Aufbrechen des Pulvers in die Nanopartikel dient.

2. Verfahren nach Anspruch 1, wobei das feste Pulver Partikel von Mikrongröße beinhaltet.

3. verfahren nach Anspruch 1, wobei sowohl das Pulver als auch die Nanopartikel kristallin sind.

4. Verfahren nach Anspruch 1, wobei die Flüssigkeit Wasser umfasst.

5. Verfahren nach Anspruch 1, wobei der Feststoff aus der aus ferroelektrischen Feststoffen und ferromagnetischen Feststoffen bestehenden Gruppe ausgewählt ist.

6. Verfahren nach Anspruch 1, wobei der Feststoff aus der aus BaT1O₃, WO₃ und Ba₂F9O₁₂ bestehenden Gruppe ausgewählt ist.

7. Verfahren nach Anspruch 1, wobei der Feststoff aus der aus Mineralien, Keramikwerkstoffen, Glasen, Metallen und synthetischen Polymeren bestehenden Gruppe ausgewählt ist.

8. Verfahren nach Anspruch 1, wobei die HF-Strahlung CW-HF-Strahlung ist.

9. Verfahren nach Anspruch 1, wobei die CW-HF-Strahlung eine Frequenz von mindestens 500 MHz aufweist.

10. Verfahren nach Anspruch 1, wobei die CW-HF-Strahlung eine Frequenz von mindestens 800 MHz aufweist.

11. Verfahren nach Anspruch 1, wobei das Pulver auf mindestens 700°C erhitzt wird.

12. verfahren nach Anspruch 1, wobei das Pulver auf mindestens 880°C erhitzt wird.

13. Nanopartikel, produziert durch das Verfahren nach Anspruch 1.

14. Ferroelektrische kristalline Nanopartikel, produziert durch das Verfahren nach Anspruch 3.

15. Ferromagnetische kristalline Nanopartikel, produziert durch das Verfahren nach Anspruch 3.

16. Piezoelektrische kristalline Nanopartikel, produziert durch das Verfahren nach Anspruch 3.

17. Vorrichtung zur Umwandlung eines Feststoffpulvers in Nanopartikel, umfassend:
(a) einen Ofen zum Erhitzen des Pulvers;
(b) einen Behälter einer Flüssigkeit, in die das heiße Pulver eingebracht wird, um das heiße Pulver abzukühlen und aufzubrechen; und
(c) einen Mechanismus zum Bestrahlen der Flüssigkeit mit HF-Strahlung, während das heiße Pulver in die Flüssigkeit eingebracht wird.

18. Vorrichtung nach Anspruch 17, wobei der Ofen ein Röhrenofen ist.

19. Vorrichtung nach Anspruch 17, weiter umfassend:
(d) ein Maschensieb zum Auswählen einer partikelgröße des Pulvers, wobei dann nur Partikel der ausgewählten Größe in dem Ofen erhitzt werden.

20. Vorrichtung nach Anspruch 17, wobei der Ofen betreibbar ist, um das Pulver auf mindestens 700°C zu erhitzen.

21. Vorrichtung nach Anspruch 17, wobei die HF-Strahlung CW-HF-Strahlung mit einer Frequenz von mindestens 500 MHz ist.

## Revendications

1. Procédé de fabrication de nanoparticules, comprenant les étapes consistant à :
(a) chauffer une poudre de produit solide ;
(b) immerger ledit produit solide dans un liquide qui est plus froid que ladite poudre chaude ; et
(c) au cours de ladite immersion, exposer ledit liquide à un rayonnement radioélectrique,
ladite immersion et ladite exposition à un rayonnement servant à fractionner ladite poudre pour obtenir les nanoparticules.

2. Procédé selon la revendication 1, dans lequel ladite poudre de produit solide englobe des particules de la dimension du micron.

3. Procédé selon la revendication 1, dans lequel à la fois ladite poudre et les nanoparticules sont cristallines.

4. Procédé selon la revendication 1, dans lequel ledit liquide englobe de l'eau.

5. Procédé selon la revendication 1, dans lequel ledit produit solide est choisi parmi le groupe constitué par des produits solides ferroélectriques et des produits solides ferromagnétiques.

6. Procédé selon la revendication 1, dans lequel ledit produit solide est choisi parmi le groupe constitué par du BaTiO₃, du WO₃ et du Ba₂F₉O₁₂.

7. Procédé selon la revendication 1, dans lequel ledit produit solide est choisi parmi le groupe constitué par des matières minérales, des matières céramiques, du verre, des métaux et des polymères synthétiques.

8. Procédé selon la revendication 1, dans lequel ledit rayonnement radioélectrique est un rayonnement électromagnétique en onde continue.

9. Procédé selon la revendication 1, dans lequel ledit rayonnement électromagnétique en onde continue possède une fréquence d'au moins 500 MHz.

10. Procédé selon la revendication 1, dans lequel ledit rayonnement électromagnétique en onde continue possède une fréquence d'au moins 800 MHz.

11. Procédé selon la revendication 1, dans lequel ladite poudre est chauffée à au moins 700 °C.

12. Procédé selon la revendication 1, dans lequel ladite poudre est chauffée à au moins 880 °C.

13. Nanoparticules obtenues via le procédé selon la revendication 1.

14. Nanoparticules cristallines ferroélectriques obtenues via le procédé selon la revendication 3.

15. Nanoparticules cristallines ferromagnétiques obtenues via le procédé selon à revendication 3.

16. Nanoparticules cristallines piézo-électriques obtenues via le procédé selon la revendication 3.

17. Appareil pour transformer une poudre de produit solide en nanoparticules, comprenant :
(a) un four pour chauffer la poudre ;
(b) un récipient contenant un liquide dans lequel on laisse tomber ladite poudre chaude afin de refroidir et de désagréger la poudre chaude ; et
(c) un mécanisme pour exposer ledit liquide à un rayonnement radioélectrique, tandis que l'on laisse tomber ladite poudre chaude dans ledit liquide.

18. Appareil selon la revendication 17, dans lequel ledit four est un four tubulaire.

19. Appareil selon la revendication 17, comprenant en outre :
(d) un tamis à mailles pour sélectionner une granulométrie de la poudre, seules les particules de ladite granulométrie sélectionnée étant alors chauffées dans ledit four.

20. Appareil selon la revendication 17, dans lequel ledit four est opérationnel pour chauffer la poudre jusqu'à au moins 700°C.

21. Appareil selon la revendication 17, dans lequel ledit rayonnement radioélectrique est un rayonnement électromagnétique en onde continue avec une fréquence d'au moins 500 MHz.
